# EUROPÄISCHE PATENTSCHRIFT

(11) **EP 0 636 575 B1**
(45) Veröffentlichungstag und Bekanntmachung des Hinweises auf die Patenterteilung: **12.03.1997**
(21) Anmeldenummer: 93112262.6
(22) Anmeldetag: 30.07.1993
(51) Int. Cl.: C01B 13/20, C01G 47/00, C01G 55/00

(54) **Verfahren zur Herstellung von Übergangsmetallen bzw. deren Oxiden**
Process for the preparation of transition metals as well as their oxides
Procédé de préparation de métaux de transition de même que de leurs oxydes

(43) Veröffentlichungstag der Anmeldung: 01.02.1995
(73) Patentinhaber: SKW Trostberg Aktiengesellschaft, 83308 Trostberg (DE)
(72) Erfinder: Herrmann, Wolfgang A., Prof. Dr. Dr. h.c., D-85354 Freising (DE); Fischer, Richard W., Dipl.-Chem., D-85716 Unterschleissheim (DE)
(74) Vertreter: Huber, Bernhard, Dipl.-Chem.

(56) Entgegenhaltungen:
- EP-A- 0 379 360
- WO-A-91/10992
- US-A- 5 075 090
- DATABASE WPI Week 9002, Derwent Publications Ltd., London, GB; AN 90-012865
- DATABASE WPI Week 7351, Derwent Publications Ltd., London, GB; AN 73-78572U

## Beschreibung

Gegenstand der vorliegenden Erfindung ist ein Verfahren zur Herstellung von Übergangsmetallen bzw. deren Oxiden, welche insbesondere zur Herstellung oxidischer Keramiken geeignet sind.

Keramische Werkstoffe zeichnen sich durch große thermische und mechanische Widerstandsfähigkeit aus, was sich aus ihrer anorganischen Natur und der geordneten Gitterstruktur ergibt. Industriell wichtige Beispiele sind Wolframcarbid als Vergütungskomponente für Schnelldreh- und Hochtemperaturwerkzeuge sowie Titannitrid als korrosionsfester Überzug von Werkteilen. Neben einer großen Zahl weiterer Carbide bzw. Nitride von metallischen Elementen haben auch Metallboride, -silicide und insbesondere Metalloxide häufig vorteilhafte Materialeigenschaften (z.B. mechanische Härte und Steifigkeit, Schlag- und Zugfestigkeit, Abriebfestigkeit, chemische Widerstandsfähigkeit, spezielle elektrische, optische oder magnetische Eigenschaften). Solche Stoffe werden in technischen Anwendungen insbesondere dann bevorzugt, wenn weitere Eigenschaften wie Adsorptionsvermögen für Katalysatoren (Heterogenkatalysatoren), für Gase (Molekularsiebe) und Flüssigkeiten (Adsorbenzien) hinzukommen oder wenn gar spezielle Licht-, Elektrizitäts- oder Magnetismusphänomene vorliegen. Ein herausragendes Beispiel ist das Rheniumtrioxid (ReO₃), das den strukturchemischen Grundtypus des "Lückenperovskits" beschreibt (ReO₃-Gittertyp) und als solcher für eine sehr große Zahl analoger Metalloxid- und verwandter Strukturen steht. Rheniumtrioxid ist außerdem ein metallisch leitender Stoff, unterscheidet sich aber von den allermeisten Metallen durch weitgehende Oxidationsresistenz.

Trotz dieser vorteilhaften Materialeigenschaften ist man in der Technik bei der Herstellung entsprechender Metalloxide auf energieaufwendige Hochtemperaturreaktionen angewiesen, die normalerweise in einer Oxidation des betreffenden Metalls bestehen. Häufig ist es sogar erforderlich, zunächst das sauerstoffreichste Derivat herzustellen und durch nachträgliche Reduktion (zumeist mit Wasserstoff bei hohen Temperaturen) den gewünschten Sauerstoffgehalt (bzw. Metalloxidationsstufe) einzustellen.

Ein grundsätzlicher, bisher weder konzeptionell noch technisch überwundener Nachteil dieser klassischen Verfahrensweisen besteht darin, daß man die entsprechenden Metalloxide nur als Bulkmaterialien erhält, zumeist als Brocken oder Pulver. Für viele Anwendungszwecke, beispielsweise Korrosionsschutz oder elektrisch leitende Überzüge, sind hingegen dünne Schichten erforderlich, deren Haftvermögen auf dem betreffenden Werkstoffteil u.a. durch die Abscheiderate (Kristallwachstum) bestimmt und deren Materialeigenschaft durch die Schichtdicke eingestellt werden kann.

US-A 5,075,090 offenbart ein Verfahren zur Herstellung von feinverteiltem Metalloxid durch Verbrennen einer Organometallverbindung. Die metallorganische Verbindung kann ein Metallalkyl oder -alkoxid sein. Das Verfahren wird durchgeführt durch Zerstäuben einer Flüssigkeit, die entweder aus mindestens einer brennbaren metallorganischen Verbindung oder einer Lösung davon mit einem brennbaren Lösungsmittel besteht, in der Gegenwart einer die Verbrennung unterstützenden Atmosphäre und Zünden des Aerosols, um die Verbrennung in Gang zu setzen.

EP-A 0 379 360 offenbart ein Verfahren zur Herstellung einer Metall enthaltenden Verbindung in feinverteilter Form durch Zersetzen einer organometallischen Verbindung in der Gasphase, in Gegenwart einer mit der organometallischen Verbindung reaktionsfähigen Reaktandenverbindung, mittels Einstrahlen von Laserenergie einer bestimmten Energiedichte, um eine aktivierte Spezies der organometallischen Verbindung zu erzeugen, die eine exotherme Kettenreaktion zwischen der organometallischen Verbindung und der Reaktantenverbindung auslöst. Als geeignete organometallische Ausgangsverbindungen werden Metallalkyle angegeben.

WO-A 91/10992 offenbart die Abscheidung einer Metallschicht auf der Oberfläche eines Substrats, das mit einer Aktivschicht aus den Ausgangsstoffen überzogen ist. Die Aktivschicht enthält eine thermisch zersetzbare metallorganische Verbindung, die, soweit eine sauerstoffhaltige Substanz betroffen ist, ein Alkoxid oder ein Ionomer wie etwa ein Carbonsäuremetallsalz ist und einen lichtabsorbierenden Farbstoff, der als Energieübermittler zur thermischen Zersetzung der metallorganischen Verbindung wirkt.

Gelegentlich werden Metallalkoholate der Formel M(OX)ₙ (M = Metall, X = Alkyl, Aryl, n = Wertigkeitsstufe des Metalls) für die Herstellung von Metalloxiden eingesetzt. Diese Verbindungen sind aber in der Regel wasserempfindlich (vgl. D.C. Bradley, Chem. Rev. 89 (1989) S. 1317) und außerdem selten ausreichend flüchtig. Schließlich sind Alkoholate von Metallen in deren höchsten Oxidationsstufen, beispielsweise + VII, bei Rhenium unbekannt.

Der vorliegenden Erfindung liegt daher die Aufgabe zugrunde, ein Verfahren zur Herstellung der Übergangsmetallelemente der Gruppen VII B und VIII B des Periodensystems mit Ausnahme von Fe, Co und Ni, in metallischer Form oder als Oxid durch Zersetzung entsprechender flüchtiger Übergangsmetallverbindungen zu entwickeln, welches die genannten Nachteile des Standes der Technik nicht aufweist, sondern ausgehend von relativ stabilen Vorprodukten die Herstellung der entsprechenden Übergangsmetalle bzw. deren Oxide in technisch einfacher Weise erlaubt.

Diese Aufgabe wurde erfindungsgemäß dadurch gelöst, daß man gemäß Anspruch 1 als Übergangsmetallverbindungen metallorganische Oxide der allgemeinen Formel RₐMe_{b}O_{c} (I) einsetzt, die mindestens eine Metall-Kohlenstoff-Bindung und eine Metall-Sauerstoff-Bindung aufweisen, wobei R
- einen gesättigten oder ungesättigten, gebenenfalls substituierten Alkylrest mit 1 bis 12 C-Atomen,
- einen mono- oder polycyclischen Kohlenwasserstoffrest mit 3 bis 12 C-Atomen,
- eine gegebenenfalls substituierte Arylgruppe mit 6 bis 10 C-Atomen oder
- einen aromatischen π-gebundenen Liganden mit 5 bis 8 C-Atomen im Zyklus,
   Me = das betreffende Übergangsmetall,
   O = Sauerstoff und
   a einen Wert von 1 bis 12,
   b einen Wert von 1 bis 3,
   c einen Wert von 1 bis 8
bedeuten.

Bevorzugte Ausführungsformen des Verfahrens werden in den Ansprüchen 2 bis 18 beansprucht. Die Verwendung des Verfahrens Zur Herstellung von elektrisch leitenden oder/und korrosionsbeständigen Überzügen bzw. Schichten wird in Anspruch 19 beansprucht.

Es hat sich nämlich überraschenderweise gezeigt, daß man mit Hilfe des erfindungsgemäßen Verfahrens durch Auswahl der metallorganischen Oxide und der Verfahrensbedingungen die Zusammensetzung und Eigenschaften der Produkte gezielt steuern kann.

Beim Verfahren der Erfindung wird ein metallorganisches Oxid der allgemeinen Formel RₐMe_{b}O_{c} einer Zersetzungsreaktion unterworfen, wobei unter metallorganischen Oxiden im Rahmen der vorliegenden Erfindung solche Verbindungen zu verstehen sind, die mindestens eine Metall-Kohlenstoff-Bindung und eine Metall-Sauerstoff-Bindung aufweisen. Der Rest R kann hierbei in weiten Grenzen variiert werden und bedeutet insbesondere einen Alkylrest mit 1 bis 12, vorzugsweise 1 bis 8 C-Atomen, der linear oder verzweigt, gesättigt oder ungesättigt und gegebenenfalls substituiert sein kann. Bevorzugte Substituenten sind hierbei Trialkyl- (insbesondere Trimethyl-)silylreste. Beispiele für solche Alkylreste sind Methyl-, Ethyl-, n-Propyl-, iso-Propyl-, n-Butyl-, iso-Butyl-, tert.-Butyl-, Neopentyl- sowie Hexyl-, Heptyl- oder Octylreste. Aufgrund der besseren Handhabbarkeit kann es u.U. auch vorteilhaft sein, auf polymere Alkylmetalloxide (wie z.B. polymeres Methyltrioxorhenium) zurückzugreifen, wobei dann bei der Zersetzung beispielsweise bei der thermischen oder photochemischen Behandlung, die vorzugsweise auch in Gegenwart von Wasser durchgeführt werden kann, die gewünschten Metalle bzw. Metalloxide gebildet werden.

Anstelle von acyclischen Alkylresten können erfindungsgemäß für R auch mono- oder polycyclische Kohlenwasserstoffreste mit 3 bis 12 C-Atomen eingesetzt werden. Beispiele für monocyclische Kohlenwasserstoffreste sind Cyclopropyl-, Cyclobutyl-, Cyclopentyl- oder Cyclohexylreste. Gegebenenfalls können diese cyclischen Kohlenwasserstoffreste noch Substituenten wie z.B. Alkyl- oder Hydroxylgruppen tragen, wie im Falle des Methylrestes. Beispiele für polycyclische Kohlenwasserstoffreste sind Norbornyl- oder Adamantylreste.

Alternativ kann R auch eine Arylgruppe mit 6 bis 10 C-Atomen darstellen, insbesondere eine Phenyl- oder Naphthylgruppe, die gegebenenfalls noch einen oder mehrere Substituenten aufweisen kann. Bevorzugte Substituenten sind hierbei Alkylgurppen, insbesondere Methylgruppen, aber auch Halogene (wie z.B. Fluor) oder Trimethylsiloxyreste. Besonders bevorzugte Arylgruppen sind Phenyl-, 2-Methylphenyl-, 2,4-Dimethylphenyl-, 2,4,6-Trimethylphenyl-, 4-Trimethylsiloxy-phenyl-, Pentafluorphenyl-, 4-Trifluormethyl-phenyl- sowie 2-Naphthylgruppen.

Schließlich kann R auch einen aromatischen π-gebundenen Liganden mit 5 bis 8 C-Atomen im Zyklus darstellen, der gegebenenfalls noch Alkylgruppen, insbesondere Methylgruppen, tragen kann. Beispiele für solche π-gebundenen Liganden sind Cyclopentadienyl- oder Pentamethylcyclopentadienyl-Reste.

Als Übergangsmetalle können im Rahmen der vorliegenden Erfindung Metalle der Elemente der Gruppen VII B und VIII B des Periodensystems mit Ausnahme von Eisen, Kobalt und Nickel eingesetzt werden. Bevorzugt werden Rhenium und Osmium verwendet. Besonders bevorzugt sind Organotrioxorheniumverbindungen. Geeignet sind auch Mn, Tc, Ru, Rh, Pd, Ir und Pt.

Die metallorganischen Oxide, die als Ausgangsmaterialien für das erfindungsgemäße Verfahren dienen, sind im Prinzip bekannt bzw. können nach bekannten Verfahren analog hergestellt werden (vgl. hierzu 1) W.A. Herrmann et al., J. Organometal. Chem. 272, 351 (1989); 2) W.A. Herrmann et al., Angew. Chem. 103, 100 (1991); 3) W.A. Herrrmann et al., Polyhedron 6, 1165 (1987); 4) W.A. Herrmann et al., Angew. Chem. 102, 1460 (1990)).

Die Zersetzung der metallorganischen Oxide kann im Rahmen der Erfindung auf verschiedenen Wegen erfolgen. Die technisch einfachste Methode ist die thermische Zersetzung der entsprechenden Vorprodukte in der Gasphase, wobei je nach Flüchtigkeit der entsprechenden Verbindung in der Regel eine Temperatur zwischen 30 und 1500°C, vorzugsweise 60 bis 600°C, erforderlich ist.

Gemäß einer bevorzugten Ausführungsform der Erfindung ist es auch möglich, die metallorganischen Oxide photochemisch zu zersetzen, was durch Bestrahlung mit Licht der Wellenlänge von 100 bis 1000 nm, vorzugsweise 150 bis 600 nm, mit den üblichen Methoden problemlos möglich ist. Die besonderen Vorteile dieser Verfahrensvariante sind die vergleichsweise niedrigen Zersetzungstemperaturen, die bei etwa -50 bis 150°C, vorzugsweise bei 0 bis 50°C, liegen sowie die Möglichkeit, die Zersetzung in einem interten Lösemittel vornehmen zu können. Dies ist bei der Durchführung in technischem Maßstab von besonderem Vorteil, weil das metallorganische Oxid in situ erzeugt werden kann und für die Durchführung des erfindungsgemäßen Verfahrens nicht isoliert werden muß, sondern in Form einer entsprechenden Lösung anfällt und so direkt für weitere Umsetzungen eingesetzt werden kann. Als Lösemittel kommen hier organische Lösemittel wie z.B. Ether oder Kohlenwasserstoffe wie z.B. Tetrahydrofuran, Dioxan oder Toluol in Frage.

Schließlich ist es im Rahmen der Erfindung auch möglich, die Zersetzung der metallorganischen Oxide durch plasmachemische Verfahren zu bewirken. Hierbei kann auf die üblichen plasmachemischen Verfahren, wie z.B. Plasma-CVD-Verfahren, entsprechend dem Stand der Technik zurückgegriffen werden. Die Zersetzungsreaktion kann dann in den üblichen Rlasmareaktoren, die hauptsächlich als Rohr- und Tunnelreaktoren oder als Parallelplattenreaktoren und Reaktoren für Coronaentladungen bekannt sind, durchgeführt werden. Für das erfindungsgemäße Verfahren kann das Plasma sowohl mit Gleichstrom als auch mit Wechselstrom oder Hochfrequenz (auch Mikrowellen) im allgemeinen im kHz- oder MHz-Bereich erzeugt werden. Die Zersetzungstemperatur bei dieser Verfahrensvariante richtet sich im wesentlichen nach der Flüchtigkeit der entsprechenden metallorganischen Verbindungen und beträgt in der Regel 20 bis 300°C.

Als besonders vorteilhaft hat es sich erwiesen, die thermische, photochemische oder plasmachemische Zersetzungsreaktion in Vakuum bei bis zu 1,33 mPa (10⁻⁵ Torr) durchzuführen, um auf diese Weise die Zersetzungstemperatur der metallorganischen Verbindung zu senken. Gemäß einer bevorzugten Ausführungsform der Erfindung wird die Zersetzung in Gegenwart von inerten Trägergasen durchgeführt, welche für den Transport der metallorganischen Verbindung in der jeweiligen Reaktionsapparatur und für die evtl. erforderliche Schutzgasatmosphäre sorgen sollen. Als Trägergas hat sich hierbei insbesondere der Einsatz von Stickstoff oder Edelgasen, wie z.B. Argon, bewährt.

Durch Auswahl der entsprechenden metallorganischen Oxide bzw. deren Verfahrensbedingungen ist es im Rahmen der vorliegenden Erfindung möglich, die Zersetzungsreaktion so zu steuern, daß man entweder die Übergangsmetalle mit hohem oder niedrigem Sauerstoffgehalt erhält.

Besitzen die metallorganischen Oxide einen vergleichsweise hohen Kohlenwasserstoffanteil (beispielsweise bei langen Alkylresten), geht der Sauerstoffanteil in den Zersetzungsprodukten gegen Null. Auch bei relativ hohen Zersetzungstemperaturen werden dann bevorzugt sauerstoffarme Produkte erhalten. Schließlich kann es auch vorteilhaft sein, das erfindungsgemäße Verfahren in Gegenwart reduzierender oder oxidierender Stoffe vorzunehmen, wobei sich der Einsatz von Wasserstoff als Reduktionsmittel bzw. von Sauerstoff als Oxidationsmittel bestens bewährt hat. Unter reduzierenden Bedingungen werden bevorzugt die metallischen Formen der Übergangsmetalle gebildet, während unter oxidativer Atmosphäre die entsprechenden Übergangsmetalloxide hergestellt werden.

Durch die Auswahl der geeigneten Zersetzungsmethode kann man beim erfindungsgemäßen Verfahren außerdem gezielt bestimmen, in welcher Form das entsprechende Übergangsmetall(-oxid) anfällt. Führt man die Zersetzungsreaktion beispielsweise photochemisch in einem geeigneten Lösemittel durch, so erhält man das entsprechende Übergangsmetall(-oxid) in Form von Pulver. Bei der Zersetzung der Vorprodukte durch thermische oder plasmachemische Verfahren werden die Produkte in Form von Schichten und/oder Filmen abgeschieden.

Es ist im Rahmen der Erfindung auch möglich, die Zersetzungsreaktion in Gegenwart von Trägermaterialien (Substraten) durchzuführen. Durch die unterschiedlichen organischen Gruppen können Flüchtigkeit bzw. Zersetzungstemperatur sowie Verdampfungsrate so eingestellt werden, daß Metallfilme kontrollierter Schichtdicke (im µm-Bereich) erhalten werden. Die so hergestellten Filme sind auf Glas, Metall, Keramik und Kunststoff (z.B. Polyethylen, Teflon) festhaftend und kratzfest. Auch temperaturlabile Substrate (wie z.B. Polyethylenfolien) können so bedampft werden. Das Verfahren der MetallBedampfung ist nicht nur auf Plankörper beschränkt; durch die teils hohen Dampfdrucke lassen sich auch sphärische Werkteile, wie z.B. aus Glas, Metall, Keramik und Kunststoff, problemlos beschichten. Auf diese Weise ist es möglich, auch elektrisch leitende Schichten, beispielsweise auf Basis von Rheniumoxid, herzustellen. Gegebenenfalls kann man diese anschließend beispielsweise durch Kunstharzlacke nach außen hin elektrisch isolieren, um bei Anwendung Kurzschlüsse zu vermeiden. Ebenso können Schichten mit besonderen optischen Eigenschaften hergestellt werden.

Das erfindungsgemäße Verfahren hat den besonderen Vorteil, daß man einerseits die Abscheidungsmethode (Temperatur-, Licht-, Plasmazersetzung) nach den Eigenschaften der Ausgangsverbindung und der angestrebten Produkte wählen kann und daß andererseits bei einer gegebenen Abscheidemethode deren Bedingungen durch die Natur der Substituenten R außerordentlich stark variiert werden können. Außerdem ist es möglich, duch die Auswahl der Verfahrensbedingungen die physikalischen Eigenschaften der abgeschiedenen Metalle bzw. Metalloxide sowie deren Sauerstoffgehalt gezielt zu beeinflussen. Darüber hinaus können die gewünschten Metalle bzw. Metalloxide nach dem erfindungsgemäßen Verfahren in sehr guten Ausbeuten und in hoher Reinheit hergestellt werden.

Die folgenden Beispiele sollen die Erfindung näher erläutern.

### Beispiele

### Beispiel 1

### a) Herstellung von Methyltrioxorhenium

Eine Lösung von 5 g (10,3 mmol) Rhenium-(VII)-oxid (Re₂O₇) in 60 ml Acetonitril wird mit 2,45 g Perfluorglutarsäureanhydrid (10,3 mmol) bei Raumtemperatur behandelt. Nach einigen Minuten setzt man 3,85 g Tetramethylzinn (20,6 mmol) zu und rührt die Lösung dann 2,5 Stunden bei Raumtemperatur. Das Acetonitril wird dann vorsichtig in einem Ölpumpenvakuum bei Raumtemperatur abgezogen. Daraufhin sublimiert man das Produkt Methyltrioxorhenium bei 65°C und einem Druck von 133 mPa 10⁻³ Torr bei einer Badtemperatur von 65°C. Die Ausbeute des sublimierten Reinprodukts beträgt 4,26 g (83 %). Der Schmelzpunkt beträgt 106°C.

### b) Thermische Zersetzung von Methyltrioxorhenium

In einer geschlossenen Zersetzungsapparatur aus Glas werden je nach der Geometrie des Abscheideapparates (meist ein Glasrohr) bzw. der zu beschichtenden Substrate (Deckgläser, kleine Probegläschen oder Metallplättchen) 1 bis 5 g Methyltrioxorhenium CH₃ReO₃ im Vakuum (1,33 Pa (0,01 Torr)) auf Temperaturen von 350 und 450°C gebracht. In Abhängigkeit von der herrschenden Zersetzungstemperatur kommt es hierbei zur quantitativen Abscheidung von Rheniumoxidschichten folgender Zusammensetzungen:
350°C: ReO_{1,90}(C_{0,07}H_{0,45}), 450°C: ReO_{1,10}(C_{0,05}H_{0,20}).
Die Schichtdicken der Filme betragen je nach Einsatzmenge und Behandlungsdauer zwischen 1 µm und 0,1 mm. Die Behandlungsdauer beträgt i.d.R. zwischen 0,5 und 3 Stunden; sie kann jedoch durch Variation des CH₃ReO₃-Partialdrucks mittels der Temperatur des Methyltrioxorhenium-Verdampfers beliebig eingestellt werden.

### Elementaranalysen/spezifischer Widerstand:

- a) Zersetzung bei 350°C:: Re: 85,4 %, O: 14,0 %, C: 0,4 %
H: 0,2 % /ρ = 0,085 mΩcm
- b) Zersetzung bei 450°C:: Re: 91,0 %, O: 8,5 %, C: 0,3 %
H: 0,1 % /ρ = 0,00 mΩcm

### Beispiel 2

### Lichtzersetzung von Methyltrioxorhenium

Zur Abscheidung von ReO₃-Schichten bei Raumtemperatur (25°C) im Vakuum (1,33 Pa (0,01 Torr)) oder auch bei tieferen Temperaturen auf Objektträger, Deckgläser und andere Substrate (gekühlt auf -40 bis 0°C) werden 1 bis 3 g CH₃ReO₃ bei Raumtemperatur aus der Dampfphase durch Bestrahlung mit dem Licht einer Quecksilberdampflampe (Wellenlänge: 185 und 253,7 nm sowie bei Hochdrucklampen: 313, 365, 436, 546 und 578 nm) während einer Reaktionsdauer von 2 bis 5 Stunden zu ReO₃-Filmen verschiedener Schichtdicken (0,1 bis 10 µm) zersetzt. Im präparativen Maßstab wurde ein Hockdruckbrenner TQ 150 der Original Quarzlampengesellschaft mbH, Hanau, der in einen Lampenschaft aus Quarzglas mit Wasserkühlung eingebracht ist, verwendet. Das Zersetzungsgefäß (vorteilhafterweise aus Quarzglas) wird entweder von außen bestrahlt, so daß die beschichteten Geräteteile ebenfalls aus Quarzglas gefertigt sein müssen, oder der Lampenschaft wird direkt über einen Schliff in die Zersetzungsapparatur eingebracht (Bestrahlung von Innen). Die Ausbeute bezogen auf Rhenium beträgt gewöhnlich ca. 80 %.
Elementaranalyse: Re: 79,6 %, O: 20,1 %, C/H: Spuren
Spezifischer Widerstand: 0,009 mΩcm

### Beispiel 3

### Plasmachemische Zersetzung von Methyltrioxorhenium

Die Zersetzungen werden in einem PECVD-Parallel-Elektroden-Reaktor (plasma enhanced chemical vapour deposition) bei niedrigen Substrattemperaturen (100°C) durchgeführt. Die verwendeten Elektroden haben einen Durchmesser von 16 cm und einen Abstand von 3 cm. Eine untere Elektrode, die bis auf 400°C geheizt werden kann, liegt an Masse, eine obere Elektrode ist über ein Netzwerk mit einem RF-Generator (13,56 MHz) verbunden. Die Substrate (meist Deckgläschen) werden auf der unteren Elektrode plaziert. Das Methyltrioxorhenium wird mittels eines thermostatisierbaren Verdampfers in die Gasphase gebracht, wobei der CH₃ReO₃-Partialdruck über die Verdampfertemperatur gesteuert werden kann. Das verdampfte Methyltrioxorhenium wird üblicherweise mit einem Argongasstrom in den Reaktor befördert. Die Filmdicken werden mit einem Profilometer (Alphastep 200®) gemessen, die Widerstandsmessungen wurden mit einem Keithley 177® Voltmeter (Vierpunktmethode) und einer Keithley 220® Stromquelle durchgeführt.

Setzt man reines Argon als Trägergas ein, so werden bei den Zersetzungen metallisch glänzende Schichten mit Rheniumgehalten von 83 bis 86 % (C ≤ 1 %) und mit spezifischen Widerständen von 0,8 bis 1,8 mΩcm erhalten; XPS-Messungen bestätigen die Existenz einer ReO₂-Schicht. Bei Verwendung eines H₂/Argon-Trägergasgemisches (80/20) erhält man metallische Beschichtungen mit einer rauhen, luftbeständigen und kratzfesten Oberfläche. Elementaranalytische Untersuchungen (Re > 99,5 %, C < 0,5 %) belegen die Bildung eines Rheniumfilmes.
Spezifischer Widerstand: 25 µΩcm
Abscheideraten zwischen 7,47 und 15,29 µg/cm² min bzw. 104 und 188 Å/min*⁾
Schichtdicken: 3000 bis 5270 Å

*⁾ 1 Å = 100 pm

Bei Zumischung von Sauerstoff zum Trägergas (5/1 und 10/1) werden stark hygroskopische Schichten mit hohen Re₂O₇-Anteilen gebildet (XPS).

### Beispiel 4

### a) Herstellung von elektrisch leitenden polymeren Methyltrioxorhenium-Schichten

Man erhitzt eine wäßrige Lösung von Methyltrioxorhenium (ca. 0,1 molar an CH₃ReO₃) unter kräftigem Rühren für ca. 24 Stunden auf Temperaturen zwischen 40 und 90°C, wobei die gewählte Reaktionstemperatur von der jeweils gewünschten Bildungsgeschwindigkeit der polymeren Organometallverbindungen abhängt. Der abfiltrierte, mit Wasser und anschließend mit absolut trockenen organischen Lösungsmitteln (THF, Diethylether, Pentan) gründlich gewaschene und im Vakuum einer Ölpumpe bei Raumtemperatur gut getrocknete goldfarbene Niederschlag von polymerem Methyltrioxorhenium wird auf entsprechende Trägersubstrate (s. Beispiel 4b) als gut haftender elektrisch leitfähiger Film beliebiger Schichtdicke mechanisch aufgetragen.

In gepufferten Lösungen (Acetatpuffer; pH = 4 bis 5) erhält man einen direkt aus der Lösung abgeschiedenen, an der Substratoberfläche gut haftenden goldfarbenen Spiegel von polymerem CH₃ReO₃. Eine besonders feine Form von polymerem CH₃ReO₃ erhält man bei Behandlung wäßriger Lösungen von CH₃ReO₃ mit Ultraschall bei 70°C.
Empirische Formel für polymeres Methyltrioxorhenium:
   C_{0,91}H_{3,3}ReO₃
Spezfischer Widerstand: 1 mΩcm

### b) Lichtzersetzung von polymerem Methyltrioxorhenium zu ReO₃-Schichten

1 bis 5 g polymeres Methyltrioxorhenium werden entsprechend Beispiel 4a auf Trägersubstrate (Glasoberflächen, metallische Oberflächen, Kunststoffteile, Papier bzw. Pappe) als gut haftender Film mechanisch aufgetragen. Der Film wird anschließend im Licht einer Quecksilberdampflampe (Wellenlänge: 185 und 253,7 nm sowie bei Hochdrucklampen: 313, 365, 436, 546 und 578 nm) in feuchter Atmosphäre während 0,5 bis 5 Stunden (je nach Schichtdicke) bei Raumtemperatur zu einem ReO₃-Film photolysiert. Die auch bei tiefen Temperaturen (-30 bis 0°C) durchführbare photochemische Zersetzung von polymerem Methyltrioxorhenium zu ReO₃ ist besonders bei temperaturempfindlichen Substraten von Vorteil.
Elementaranalyse: Re: 79,5 %, O: 20,5 %
Spezifischer Widerstand: 40 µΩcm

### c) Thermische Zersetzung von polymerem Methyltrioxorhenium zu ReO₃-Pulver

1 bis 5 g polymeres Methyltrioxorhenium werden in Form einer Schüttung unter Schutzgasatmosphäre (Stickstoff oder Argon) bei Temperaturen zwischen 150 und 300°C innerhalb 0,5 bis 18 Stunden (variabel je nach gewünschter Bildungsgeschwindigkeit) zu einem hochreinen ReO₃-Pulver thermolysiert.
Ausbeute bezogen auf eingesetztes Rhenium: 98 %
Elementaranalyse: Reinheit des ReO₃ > 99,9 %
Spezifischer Widerstand: 45 µΩcm

### Beispiel 5

### Thermische Zersetzung von Ethyltrioxorhenium

In einem mit dem zur Abscheidung heizbaren Glasrohr vakuumdicht verbundenen Schlenkgefäß werden unter Schutzgas (Stickstoff) 0,5 bis 1 g farbloses, bei Raumtemperatur flüssiges Ethyltrioxorhenium vorgelegt. Bei einem Druck von 0,01 Torr wird das flüchtige Ethyltrioxorhenium innerhalb einer Stunde in der heißen Zone des Zersetzungsrohres bei Temperaturen von 300 und 400°C vollständig in Form eines metallisch glänzenden Rheniumoxidfilmes auf der Rohrinnenseite und auf vorher im Rohr plazierten Objekten (Deckgläschen, Glasröhrchen φ = 1 cm) abgeschieden. Der Film ist polierbar und kratzfest. Die Ausbeute bezogen auf Rhenium ist nahezu vollständig (98 %). Die einfache analytische Kontrolle des Rheniumoxidfilms gelingt durch die Aufnahme von IR-Spektren (KBr-Preßling oder diffuse Reflexion) der abgeschiedenen Schichten (ReO₃[KBr; cm⁻¹]: 1261, 1083, 1024, 912, 800).
Schichtzusammensetzungen:
   bei 300°C: ReO_{1,2}(C_{0,04}H_{0,23})
   bei 400°C: ReO_{0,4}(C_{0,14}H_{0,36})

### Beispiel 6

### Thermische Zersetzung von Silaneopentyltrioxorhenium

1 bis 2 g festes farbloses Silaneopentyltrioxorhenium (CH₃)₃SiCH₂ReO₃ werden analog Beispiel 1b (bzgl. Schichtdicke, Behandlungsdauer etc.) bei 300 und 400°C in der Abscheideapparatur zu Filmen folgender Zusammensetzung zersetzt:
- bei 300°C:: ReO₂ mit 0,7 % Si
(Spezifischer Widerstand: 6,3 mΩcm)
- bei 400°C:: ReO_{0,9}

### Beispiel 7

### Thermische Zersetzung von Pentamethylcyclopentadienyltrioxorhenium

1 bis 5 g Pentamethylcyclopentadienyltrioxorhenium [C₅(CH₃)₅]ReO₃ werden analog Beispiel 1b bei 450 und 600°C zu Filmen zersetzt. Die Abscheidegeschwindigkeit läßt sich hier (ähnlich wie bei Beispiel 1) besonders bequem duch Regulation der Sublimationsgeschwindigkeit des Eduktes mittels des herrschenden Druckes und der Temperatur des Verdampfergefässes steuern, wobei folgende Zusammensetzungen erhalten wurden:
- bei 450°C:: ReO_{0,14}(C_{0,33}H_{0,22})
- bei 600°C:: Re(C_{0,30}H_{0,30})
(Spezifischer Widerstand: 30 µΩcm)

### Beispiel 8

### Thermische Zersetzung von Tetramethyloxoosmium

1 bis 2 g Tetramethyloxoosmium werden analog Beispiel 1b in einer Abscheideapparatur im Vakuum (1,33 bis 13,3 Pa (0,01 bis 0,1 Torr) bei Temperaturen zwischen 350 und 550°C auf kleine Deckgläschen (Kantenlänge 2 cm) zu einer schwarzen Osmiumschicht (Schichtdicken je nach Behandlungsdauer bzw. Abscheidegeschwindigkeit zwischen 0,1 und 100 µm) mit geringen Sauerstoff- und Kohlenstoffanteilen zersetzt. Ausbeute bezogen auf Osmium: 80 %.
Elementaranalyse: Os: 97 %, O: 2 %, C: 0,3 %, H: 0,2 %
Spezifischer Widerstand: 46 µΩcm

### Beispiel 9

0,5 g Methyl(oxo)bis(η²-peroxo)rhenium(VII)-Hydrat (CH₃(O₂)₂ReO·H₂O) werden analog Beispiel 1b in einer Abscheideapparatur im Vakuum (1,33 bis 13,3 Pa (0,01 bis 0,1 Torr)) bei 400°C zersetzt (Dauer: 2 Stunden), wobei ein Rheniumoxidfilm der Zusammensetzung Re₂O₇ erhalten wurde.

## Patentansprüche

1. Verfahren zur Herstellung der Übergangsmetallelemente der Gruppen VII B und VIII B des Periodensystems mit Ausnahme von Fe, Co und Ni, in metallischer Form oder als Oxid durch Zersetzung entsprechender flüchtiger Übergangsmetallverbindungen,
**dadurch gekennzeichnet,**
daß man als Übergangsmetallverbindungen metallorganische Oxide der allgemeinen Formel RₐMe_{b}O_{c} (I) einsetzt,
die mindestens eine Metall-Kohlenstoff-Bindung und eine Metall-Sauerstoff-Bindung aufweisen, wobei
R
- einen gesättigten oder ungesättigten, gebenenfalls substituierten Alkylrest mit 1 bis 12 C-Atomen,
- einen mono- oder polycyclischen Kohlenwasserstoffrest mit 3 bis 12 C-Atomen,
- eine gegebenenfalls substituierte Arylgruppe mit 6 bis 10 C-Atomen oder
- einen aromatischen π-gebundenen Liganden mit 5 bis 8 C-Atomen im Zyklus,
Me = das betreffende Übergangsmetall,
O = Sauerstoff und
a einen Wert von 1 bis 12,
b einen Wert von 1 bis 3,
c einen Wert von 1 bis 8
bedeuten.

2. Verfahren nach Anspruch 1,
**dadurch gekennzeichnet,**
daß man die metallorganischen Oxide in der Gasphase bei einer Temperatur von 30 bis 1500°C, vorzugsweise 60 bis 600°C, thermisch zersetzt.

3. Verfahren nach Anspruch 1,
**dadurch gekennzeichnet,**
daß man die Zersetzung der metallorganischen Oxide photochemisch durch Bestrahlung mit Licht der Wellenlänge 100 bis 1000 nm, vorzugsweise 150 bis 600 nm, vornimmt.

4. Verfahren nach Anspruch 3,
**dadurch gekennzeichnet,**
daß die photochemische Behandlung in einem Temperaturbereich von -50°C bis 150°C, vorzugsweise 0 bis 50°C, erfolgt.

5. Verfahren nach Anspruch 1,
**dadurch gekennzeichnet,**
daß man die Zersetzung der metallorganischen Oxide durch plasmachemische Verfahren bewirkt.

6. Verfahren nach einem der Ansprüche 1 bis 5,
**dadurch gekennzeichnet,**
daß man die Zersetzung bei einem Vakuum bis zu 1,33 x 10⁻³ Pa (1 x 10⁻⁵ Torr) durchführt.

7. Verfahren nach einem der Ansprüche 1 bis 6,
**dadurch gekennzeichnet,**
daß man die Zersetzung der metallorganischen Oxide in Gegenwart von inerten Trägergasen durchführt.

8. Verfahren nach Anspruch 7,
**dadurch gekennzeichnet,**
daß man als Inertgas Argon verwendet.

9. Verfahren nach einem der Ansprüche 1 bis 8,
**dadurch gekennzeichnet,**
daß man die Zersetzung unter reduzierenden Bedingungen durchführt.

10. Verfahren nach Anspruch 9,
**dadurch gekennzeichnet,**
daß man zur Einstellung reduzierender Bedingungen Wasserstoff verwendet.

11. Verfahren nach den Ansprüchen 1 bis 8,
**dadurch gekennzeichnet,**
daß man die Zersetzung in oxidierender Atmosphäre durchführt.

12. Verfahren nach Anspruch 11,
**dadurchh gekennzeichnet,**
daß man eine Sauerstoff-haltige oxidierende Atmosphäre verwendet.

13. Verfahren nach einem der vorhergehenden Ansprüche,
**dadurch gekennzeichnet,**
daß man das metallorganische Oxid in polymerer Form einsetzt.

14. Verfahren nach Anspruch 13,
**dadurch gekennzeichnet,**
daß man das polymere metallorganische Oxid gegebenenfalls in Gegenwart von Wasser photochemisch zersetzt.

15. Verfahren nach einem der vorhergehenden Ansprüche 1-14,
**dadurch gekennzeichnet,**
daß man zur Herstellung der Übergangsmetalloxide in Form von Schichten und/oder Filmen die Zersetzung in Gegenwart von Trägermaterialien (Substraten) durchführt.

16. Verfahren nach Anspruch 15,
**dadurch gekennzeichnet,**
daß man als Substrat Glas, Keramik, Metall oder Kunststoff verwendet.

17. Verfahren nach einem der vorhergehenden Ansprüche,
**dadurch gekennzeichnet,**
daß man als metallorganisches Oxid wenigstens eine Verbindung aus der Gruppe Methyltrioxorhenium, Ethyltrioxorhenium, Silaneopentyltrioxorhenium, Pentamethylcyclopentadienyltrioxorhenium, Tetramethyloxoosmium, Methyl(oxo)bis(n²-peroxo)rhenium(VII)-hydrat einsetzt.

18. Verfahren nach einem der Ansprüche 1 bis 16,
**dadurch gekennzeichnet,**
daß man eine Organotrioxorheniumverbindung einsetzt.

19. Anwendung des Verfahrens nach einem der vorhergehenden Ansprüche für die Herstellung von elektrisch leitenden oder/und korrosionsbeständigen Überzügen bzw. Schichten.

## Claims

1. Method for producing the transition-metal elements of Groups VII B and VIII B of the Periodic Table with the exception of Fe, Co and Ni, in metallic form or as oxides, by the decomposition of corresponding volatile transition metal compounds,
characterised in that
there are used as transition metal compounds metallo-organic oxides with the general formula RₐMe_{b}O_{c} (I), which have at least one metal-carbon bond and one metal-oxygen bond, where
R signifies
- a saturated or unsaturated, optionally substituted alkyl radical with 1 to 12 C-atoms,
- a mono- or polycyclic hydrocarbon radical with 3 to 12 C-atoms,
- an optionally substituted aryl group with 6 to 10 C-atoms or
- an aromatic π-bonded ligand with 5 to 8 C-atoms in the ring,
Me = the transition metal concerned,
O = oxygen and
a signifies a value from 1 to 12,
b a value from 1 to 3 and
c a value from 1 to 8.

2. Method according to claim 1,
characterised in that
the metallo-organic oxides are decomposed thermally in the gas phase at a temperature of 30 to 1500 °C, preferably 60 to 600 °C.

3. Method according to claim 1,
characterised in that
the decomposition of the metallo-organic oxides is undertaken photochemically by radiation with light of the wavelength 100 to 1000 nm, preferably 150 to 600 nm.

4. Method according to claim 3,
characterised in that
the photochemical treatment takes place in a temperature range from -50 °C to 150 °C, preferably 0 to 50 °C.

5. Method according to claim 1,
characterised in that
the decomposition of the metallo-organic oxides is brought about by plasma-chemical methods.

6. Method according to any one of claims 1 to 5,
characterised in that
the decomposition is carried out with a vacuum up to 1.33 x 10⁻³ Pa (1 x 10⁻⁵ Torr).

7. Method according to any one of claims 1 to 6,
characterised in that
the decomposition of the metallo-organic oxides is carried out in the presence of inert carrier gases.

8. Method according to claim 7,
characterised in that
argon is used as inert gas.

9. Method according to any one of claims 1 to 8,
characterised in that
the decomposition is carried out under reducing conditions.

10. Method according to claim 9,
characterised in that
hydrogen is used for the setting of reducing conditions.

11. Method according to claims 1 to 8,
characterised in that
the decomposition is carried out in an oxidizing atmosphere.

12. Method according to claim 11,
characterised in that
an oxygen-containing oxidizing atmosphere is used.

13. Method according to any one of the preceding claims,
characterised in that
the metallo-organic oxide is used in polymeric form.

14. Method according to claim 13,
characterised in that
the polymeric metallo-organic oxide is decomposed photochemically optionally in the presence of water.

15. Method according to any one of the preceding claims 1 - 14,
characterised in that
in order to produce the transition-metal oxides in the form of layers and/or films the decomposition is carried out in the presence of support materials (substrates).

16. Method according to claim 15,
characterised in that
glass, ceramic, metal or plastic is used as the substrate.

17. Method according to any one of the preceding claims,
characterised in that
there is used as the metallo-organic oxide at least one compound from the group methyltrioxorhenium, ethyltrioxorhenium, silaneopentyltrioxorhenium, pentamethylcyclo-pentadienyltrioxorhenium tetramethyloxoosmium, methyl-(oxo)bis(n²-peroxo)rhenium(VII) hydrate.

18. Method according to any one of claims 1 to 16,
characterised in that
an organic trioxorhenium compound is used.

19. Application of the method according to any one of the preceding claims for the production of electrically conductive and/or corrosion-resistant coatings or layers.

## Revendications

1. Procédé de préparation des éléments de métaux de transition des groupes VIIB et VIIIB de la classification périodique des éléments à l'exclusion des Fe, Co et Ni, à l'état métallique ou sous forme d'oxyde par décomposition de composés de métaux de transition volatils correspondants, caractérisé en ce que l'on met en oeuvre comme composés de métaux de transition des oxydes organo-métalliques de formule générale RₐMe_{b}O_{c} (I) comportant au moins une liaison métal-carbone et une liaison métal-oxygène, auquel cas
R signifie un reste alkyle saturé ou insaturé, éventuellement substitué comportant 1 à 12 atomes de C,
- un reste hydrocarboné mono- ou polycyclique ayant 3 à 12 atomes de C,
- un groupe aryle éventuellement substitué comportant 6 à 10 atomes de C ou
- un ligand aromatique à liaison π possédant 5 à 8 atomes de C dans le cycle,
Me = le métal de transition concerné
0 = oxygène et
a représente une valeur de 1 à 12,
b une valeur de 1 à 3,
c une valeur de 1 à 8.

2. Procédé selon la revendication 1, caractérisé en ce que l'on décompose thermiquement les oxydes organo-métalliques en phase gazeuse à une température de 30 à 1500°C, de préférence de 60 à 600°C.

3. Procédé selon la revendication 1, caractérisé en ce que l'on procède à la décomposition des oxydes organo-métalliques par voie photochimique par irradiation avec de la lumière d'une longueur d'onde de 100 à 1000 nm, de préférence de 150 à 600 nm.

4. Procédé selon la revendication 3, caractérisé en ce que le traitement photochimique a lieu dans une plage de températures de -50°C à 150°C, de préférence de 0 à 50°C.

5. Procédé selon la revendication 1, caractérisé en ce qu'on provoque la décomposition des oxydes organo-métalliques par des procédés plasma-chimiques.

6. Procédé selon l'une des revendications 1 à 5, caractérisé en ce qu'on effectue la décomposition sous un vide jusqu'à 1,33 x 10⁻³ Pa (1 x 10⁻⁵ torr).

7. Procédé selon l'une des revendications 1 à 6, caractérisé en ce qu'on effectue la décomposition des oxydes organométalliques en présence de gaz vecteurs inertes.

8. Procédé selon la revendication 7, caractérisé en ce qu'on emploie de l'argon comme gaz inerte.

9. Procédé selon l'une des revendications 1 à 8, caractérisé en ce qu'on effectue la décomposition dans des conditions réductrices.

10. Procédé selon la revendication 9, caractérisé en ce qu'on utilise de l'hydrogène pour l'établissement des conditions réductrices.

11. Procédé selon l'une des revendications 1 à 8, caractérisé en ce qu'on effectue la décomposition en atmosphère oxydante.

12. Procédé selon la revendication 11, caractérisé en ce qu'on utilise une atmosphère oxydante contenant de l'oxygène.

13. Procédé selon l'une des revendications précédentes, caractérisé en ce qu'on met en oeuvre l'oxyde organométallique sous forme polymère.

14. Procédé selon la revendication 13, caractérisé en ce qu'on décompose l'oxyde organométallique polymère par voie photochimique, éventuellement en présence d'eau.

15. Procédé selon l'une des revendications précédentes 1 à 14, caractérisé en ce que, pour la préparation des oxydes de métaux de transition sous forme de couches et/ou de films, on effectue la décomposition en présence de supports (substrats).

16. Procédé selon la revendication 15, caractérisé en ce qu'on emploie comme substrat du verre, de la céramique, du métal ou de la matière synthétique.

17. Procédé selon l'une des revendications précédentes, caractérisé en ce qu'on met en oeuvre, en tant qu'oxyde organométallique, au moins un composé du groupe des méthyltrioxorhénium, éthyltrioxorhénium, silanéopentyltrioxorhénium, pentaméthylcyclopentadiényltrioxorhénium, tétraméthyloxoosmium, hydrate de méthyl-(oxo)bis(n²-peroxo)rhénium(VII).

18. Procédé selon l'une des revendications 1 à 16, caractérisé en ce qu'on met en oeuvre un composé organotrioxorhénium.

19. Utilisation du procédé selon l'une des revendications précédentes pour la préparation de revêtements, respectivt. de couches électroconductrices ou/et résistantes à la corrosion.
